# EUROPEAN PATENT APPLICATION

(11) **EP 4 727 070 A1**
(43) Date of publication of application: **15.04.2026**
(21) Application number: 25192440.3
(22) Date of filing: 29.07.2025
(51) Int. Cl.: H04L 25/02, H04L 12/40

(54) **CAN TRANSCEIVER**

(30) Priority: 12.10.2024 CN 202411425868
(71) Applicant: Suzhou Novosense Microelectronics Co., Ltd., Suzhou, Jiangsu 215000 (CN)
(72) Inventor: HU, Peng, Jiangsu, 215000 (CN); SUN, Yuanjie, Jiangsu, 215000 (CN); LIU, Binjie, Jiangsu, 215000 (CN)
(74) Representative: Murgitroyd & Company

(57) **Abstract**

A CAN transceiver including a data transmission port, a high-side bus port, a low-side bus port, an output stage circuit, a first regulation circuit and a second regulation circuit. The first regulation circuit and the second regulation circuit eliminate errors of differential signals by receiving abnormal voltage signals and outputting regulation signals to increase a pull-up current or a pull-down current in the output circuit, the first regulation circuit regulates errors generated by abnormal positive high-voltage pulses coupled into the high-side bus port, and the second regulation circuit regulates errors generated by abnormal negative high-voltage pulses coupled into the low-side bus port; after the CAN transceiver applies the first regulation circuit and the second regulation circuit, influence of abnormal high-voltage pulse signals in a CAN bus on errors of output signals of the CAN transceiver is reduced, and EMC performance of the CAN transceiver is improved.

## Description

### TECHNICAL FIELD

The present application belongs to the technical field of CAN transceivers, and specifically relates to a CAN transceiver.

### BACKGROUND

A CAN transceiver is a key component in CAN (Controller Area Network) bus communication, used for data transmission between a CAN bus and a CAN controller, converting a single-ended signal output by the CAN controller into a differential signal required by the CAN bus, and converting the differential signal on the CAN bus back into a single-ended signal to transmit to the CAN controller. Due to the complex electromagnetic environment in application scenarios of CAN bus communication, a CAN transceiver is usually subject to abnormal high-voltage interference. For example, the vehicle-mounted electrical environment may cause positive and negative high voltages of tens or even hundreds of volts to be coupled into the CAN bus, which makes a protection diode in an output stage circuit of the CAN transceiver generate a reverse recovery current during the process of changing from forward conduction to reverse cutoff, causing an output state of the CAN transceiver to change from dominant to recessive, thereby affecting the stability of differential signals.

### SUMMARY

The present application provides a CAN transceiver to solve the problem that the output circuit of the current CAN transceiver is susceptible to abnormal high-voltage interference, leading to errors in the output signal of the CAN transceiver, so as to improve the EMC (Electromagnetic Compatibility) of the CAN transceiver.

According to a first aspect of the present application, the present application provides a CAN transceiver, including: a data transmission port, configured to receive a data transmission signal; a high-side bus port, configured to output a high-side bus signal; a low-side bus port, configured to output a low-side bus signal; a high-side transistor, having a first terminal, a second terminal, and a third terminal, wherein the first terminal of the high-side transistor is configured to receive a supply voltage, and the second terminal of the high-side transistor is configured to receive a high-side gate signal; a high-side switching transistor, having a first terminal coupled to the third terminal of the high-side transistor, and a second terminal coupled to the high-side bus port, wherein a voltage at the first terminal of the high-side switching transistor is a high-side detection voltage; a low-side transistor, having a first terminal, a second terminal, and a third terminal, wherein the first terminal is coupled to a reference ground, and the second terminal is configured to receive a low-side gate signal; a low-side switching transistor, having a first terminal coupled to the low-side bus port, and a second terminal coupled to the third terminal of the low-side transistor, wherein a voltage at the second terminal of the low-side switching transistor is a low-side detection voltage; a first regulation circuit, having a first input terminal and a second input terminal, wherein the first input terminal of the first regulation circuit is configured to receive the supply voltage, and the second input terminal of the first regulation circuit is configured to receive the high-side detection voltage, wherein the first regulation circuit is configured to generate a first regulation signal according to the supply voltage and the high-side detection voltage; a second regulation circuit, having a first input terminal and a second input terminal, wherein the first input terminal of the second regulation circuit is coupled to the reference ground, and the second input terminal of the second regulation circuit is configured to receive the low-side detection voltage, wherein the second regulation circuit is configured to generate a second regulation signal according to the reference ground and the low-side detection voltage; and a logic circuit, configured to generate the high-side gate signal and the low-side gate signal according to the data transmission signal, the first regulation signal, and the second regulation signal; wherein when the high-side detection voltage is greater than a sum of the supply voltage and a first threshold, a forward current flowing through the low-side switching transistor increases; and when the low-side detection voltage is less than a second threshold, a forward current flowing through the high-side switching transistor increases.

According to a second aspect of the present application, the present application provides a CAN transceiver, including: a data transmission port, configured to receive a data transmission signal; a high-side bus port, configured to output a high-side bus signal; a low-side bus port, configured to output a low-side bus signal; a high-side transistor, having a first terminal, a second terminal, and a third terminal, wherein the first terminal of the high-side transistor is configured to receive a supply voltage, and the second terminal of the high-side transistor is configured to receive the data transmission signal; a high-side switching transistor, having a first terminal coupled to the third terminal of the high-side transistor, and a second terminal coupled to the high-side bus port, wherein a voltage at the first terminal of the high-side switching transistor is a high-side detection voltage; a low-side transistor, having a first terminal, a second terminal, and a third terminal, wherein the first terminal of the low-side transistor is coupled to a reference ground, and the second terminal of the low-side transistor is configured to receive a data transmission inverted signal; a low-side switching transistor, having a first terminal coupled to the low-side bus port, and a second terminal coupled to the third terminal of the low-side transistor, wherein a voltage at the second terminal of the low-side switching transistor is a low-side detection voltage; a first regulation circuit, having a first input terminal and a second input terminal, wherein the first input terminal of the first regulation circuit is configured to receive the supply voltage, and the second input terminal of the first regulation circuit is configured to receive the high-side detection voltage, wherein the first regulation circuit generates a first regulation signal according to the supply voltage and the high-side detection voltage; a second regulation circuit, having a first input terminal and a second input terminal, wherein the first input terminal of the second regulation circuit is coupled to the reference ground, and the second input terminal of the second regulation circuit is configured to receive the low-side detection voltage, wherein the second regulation circuit generates a second regulation signal according to the reference ground and the low-side detection voltage; a first regulation transistor, having a first terminal, a second terminal, and a third terminal, wherein the first terminal of the first regulation transistor is coupled to the second terminal of the low-side switching transistor, the second terminal of the first regulation transistor is coupled to the reference ground, and the third terminal of the first regulation transistor is configured to receive the first regulation signal; and a second regulation transistor, having a first terminal, a second terminal, and a third terminal, wherein the first terminal of the second regulation transistor is coupled to the supply voltage, the second terminal of the second regulation transistor is coupled to the first terminal of the high-side switching transistor, and the third terminal of the second regulation transistor is configured to receive the second regulation signal; wherein when the high-side detection voltage is greater than a sum of the supply voltage and a first threshold, a forward current flowing through the low-side switching transistor increases; and when the low-side detection voltage is less than a second threshold, a forward current flowing through the high-side switching transistor increases.

Through one or more of the above embodiments of the present invention, at least the following technical effects can be achieved.

In embodiments, the regulation circuit samples the terminal voltage of the switching transistor in the output circuit of the CAN transceiver, realizes the detection of abnormal high-voltage pulses by acquiring voltage signals, generates a regulation signal using the abnormal voltage signal, and further regulates the abnormal CAN bus current caused by the abnormal high-voltage pulses. This ensures that differential signals do not have errors even when the high-side output current or the low-side output current of the CAN transceiver is abnormal, thereby improving the anti-interference capability of the CAN transceiver, and enhancing the EMC of the CAN transceiver.

### BRIEF DESCRIPTION OF THE DRAWINGS

To more clearly illustrate the technical solutions in the embodiments of the present application, the following will briefly introduce the drawings required in the description of the embodiments. Obviously, the drawings in the following description are only some embodiments of the present application. For those skilled in the art, other drawings can also be obtained based on these drawings without exerting creative labor.
Figure 1 is a schematic structural diagram of an output stage circuit of an existing CAN transceiver;
Figure 2 is a signal timing diagram of an output stage circuit of an existing CAN transceiver;
Figure 3 is a schematic diagram of a circuit structure of a CAN transceiver according to an embodiment of the present invention;
Figure 4 is a schematic diagram of a logic switch S2 according to an embodiment of the present invention;
Figure 5 is a schematic diagram of a circuit structure of a CAN transceiver according to an embodiment of the present invention;
Figure 6 is an example diagram of signal timing of circuits of the CAN transceiver in various embodiments of the present invention.

### DETAILED DESCRIPTION

The following will clearly and completely describe the technical solutions in the embodiments of the present application in conjunction with the accompanying drawings in the embodiments of the present application. Obviously, the described embodiments are only a part of the embodiments of the present application, rather than all the embodiments. Based on the embodiments in the present application, all other embodiments obtained by those skilled in the art without making creative efforts shall fall within the protection scope of the present application.

It should be noted that the terms "first", "second" and the like in the description and claims of the present application and the above drawings are used to distinguish similar objects, and are not necessarily used to describe a specific sequence or order. It should be understood that the data used in this way can be interchanged under appropriate circumstances, so that the embodiments of the present application described herein can be implemented in an order other than those illustrated or described herein. In addition, the terms "comprise" and "have" and any variations thereof are intended to cover non-exclusive inclusion. For example, a process, method, system, product or device that includes a series of steps or units is not necessarily limited to those steps or units clearly listed, but may include other steps or units that are not clearly listed or are inherent to such processes, methods, products or devices.

It should be understood that in the following description, a "circuit" refers to a conductive loop formed by at least one element or sub-circuit through electrical connection or electromagnetic connection. When an element or circuit is said to be "connected to" another element or an element/circuit is said to be "connected between" two nodes, it can be directly coupled or connected to the other element, or there may be an intermediate element, and the connection between elements can be physical, logical, or a combination thereof. Conversely, when an element is said to be "directly coupled to" or "directly connected to" another element, it means that there is no intermediate element between the two.

In the application scenario of CAN bus communication, the complex electrical environment may have high-voltage pulse interference, such as sudden Impulse (IMP) events or Direct Power Injection (DPI) events in the vehicle-mounted electrical environment. Therefore, diodes are usually used in CAN transceivers for transient high-voltage protection. Under normal circumstances, the difference signal between the high-side bus signal CANH and the low-side bus signal CANL in the CAN bus is defined as the differential signal VDIFF of the CAN bus. When the high-side bus signal CANH is at a logic high level and the low-side bus signal CANL is at a logic low level, the actual level difference between the two is large, and the differential signal VDIFF is in a state of logic high level, which indicates that the CAN bus operates in a dominant state. When the high-side bus signal CANH is at a logic low level and the low-side bus signal CANL is at a logic high level, the actual level difference between the two is small, and the differential signal VDIFF is in a state of logic low level, which indicates that the CAN bus operates in a recessive state. When an IMP event or a DPI event occurs, due to the influence of instantaneous high voltage, the diode may switch from forward conduction to reverse cutoff. Since the diode has a diffusion capacitance when it is forwardly conducted, when the bias of the diode switches from positive voltage to negative voltage, it takes a period of time to reversely charge the voltage of the diffusion capacitance. At the same time, the carriers inside the diode need a certain time to recombine completely and disappear, after which the internal voltage drop of the diode can truly reach a negative voltage and the diode can be completely cut off. During this period, the current seen from the outside of the diode flows from the cathode to the anode of the diode, so it is called the reverse recovery current of the diode. The existence of this reverse recovery current may cause the input and output state of the CAN bus to change from a logic high level to a logic low level, thus causing the communication on the CAN bus to be interfered by errors, and the transmitted message may be mistakenly considered as in a recessive state instead of the expected dominant state. Similarly, when a field effect transistor is used as a protection switching transistor inside the CAN transceiver, the parasitic diode inside the field effect transistor will also have a reverse recovery current under the influence of instantaneous high voltage, leading to abnormal input and output states and errors of the CAN bus.

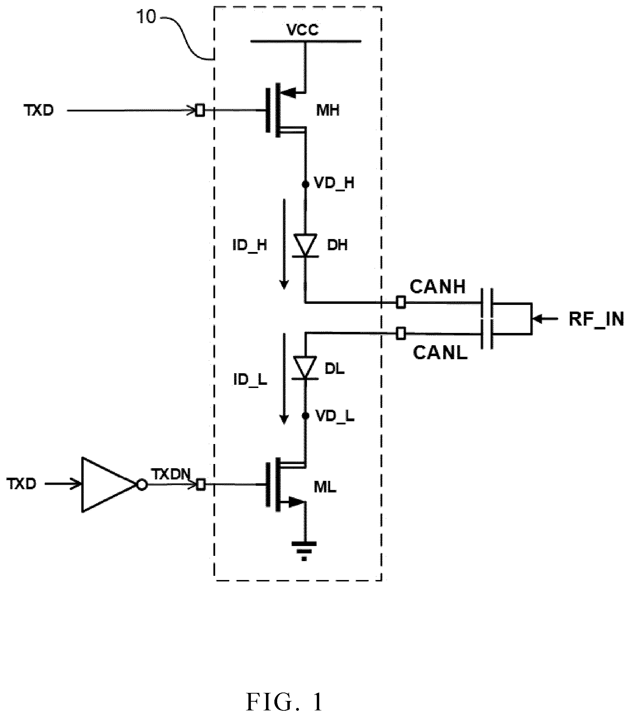

Figure 1 is a schematic structural diagram of an output stage circuit of an existing CAN transceiver. As shown in Figure 1, the output stage circuit 10 of the CAN transceiver includes a high-side transistor MH, a high-side switching transistor DH, a low-side switching transistor DL, and a low-side transistor ML. The gate terminal of the high-side transistor MH receives a data transmission signal TXD, and the gate terminal of the low-side transistor ML receives a data transmission inverted signal TXDN, that is, the data transmission signal TXD and the data transmission inverted signal TXDN of the CAN transceiver are used as control signals of the high-side transistor MH and the low-side transistor ML respectively. When the TXD signal is dominant, the gate terminal voltage of the high-side transistor MH is at a low level, the high-side transistor MH is turned on, the high-side switching transistor DH is forwardly conducted, and the high-side bus port CANH outputs the forward conduction current ID_H of the high-side switching transistor DH, that is, the high-side bus signal CANH is at a logic high level. At this time, the TXDN signal is at a high level, that is, the gate terminal voltage of the low-side transistor ML is at a high level, which controls the low-side transistor ML to be turned on, the low-side switching transistor DL is forwardly conducted, and the low-side bus port CANL outputs the forward conduction current ID_L of the low-side switching transistor DL, that is, the low-side bus signal CANL is at a logic low level. At this time, the differential signal in the CAN bus is at a logic high level, indicating that the CAN bus is in a dominant state. When the TXD signal is recessive, the gate terminal voltage of the high-side transistor MH is at a high level, the high-side transistor MH is turned off, the high-side switching transistor DH is cut off, the forward conduction current ID_H of the high-side switching transistor DH is approximately zero, and the high-side bus signal CANH is at a logic low level. At this time, the TXDN signal is at a low level, that is, when the gate terminal voltage of the low-side transistor ML is at a low level, the low-side transistor ML is cut off, the low-side switching transistor DL is cut off, the forward conduction current ID_L of the low-side switching transistor DL is approximately zero, and the low-side bus signal CANL is at a logic high level. Since both the high-side switching transistor DH and the low-side switching transistor DL are cut off, the voltages of the high-side bus and the low-side bus in the CAN bus are close, that is, the differential signal in the CAN bus is at a logic low level, indicating that the CAN bus is in a recessive state.

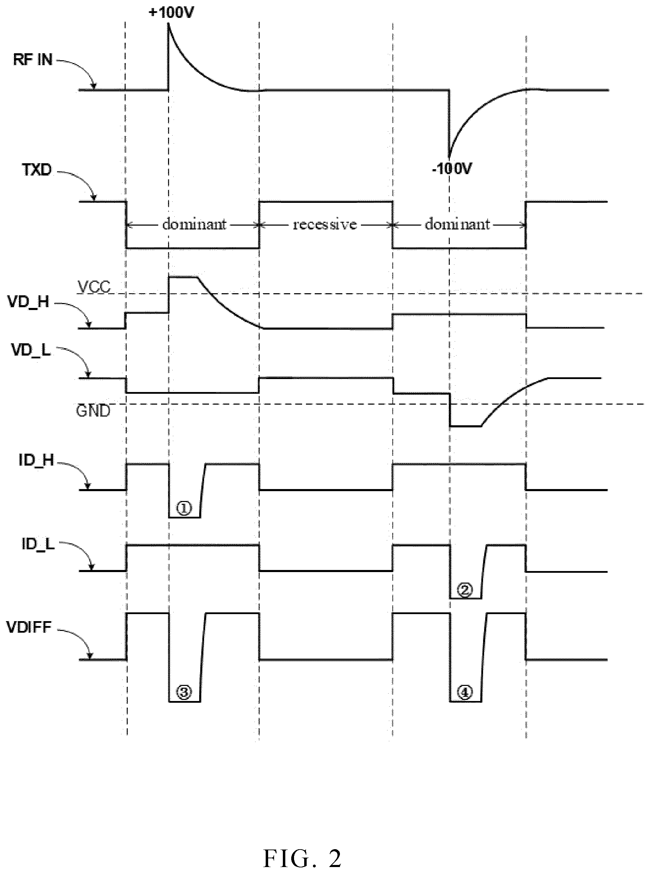

Figure 2 is a signal timing diagram of an output stage circuit of an existing CAN transceiver, which is used to illustrate the problem in EMC performance of the output stage circuit structure of the existing CAN transceiver shown in Figure 1. Taking a sudden IMP event or DPI event causing a +100V high-voltage interference in the CAN bus as an example, when a high-voltage interference signal RF_IN is coupled into the CAN bus through a capacitor, if the TXD signal is dominant at this time, at the moment when the IMP event or DPI event occurs, the voltage at the cathode terminal of the high-side switching transistor DH rises sharply, the bias state of the high-side switching transistor DH switches from forward conduction to reverse cutoff, and the reverse recovery current of the high-side switching transistor DH flows from the cathode to the anode of the high-side switching transistor DH, causing the high-side detection voltage VD_H in Figure 2 to have a high voltage exceeding the supply voltage VCC at the moment when the +100V high voltage occurs, and the forward conduction current ID_H of the high-side switching transistor DH transitions at this time ①, that is, the forward conduction current ID_H of the high-side switching transistor DH cannot be cut off to 0 at the moment when the high-side switching transistor DH switches to reverse cutoff, but a reverse current appears, leading to a polarity transition of the high-side bus signal CANH in the CAN bus, and then leading to a corresponding transition of the differential signal VDIFF in the CAN bus ③, that is, an error occurs. Similarly, when a sudden IMP event or DPI event causes a -100V high-voltage interference in the CAN bus, and the TXD signal is dominant at this time, at the moment when the IMP event or DPI event occurs, the voltage at the anode terminal of the low-side switching transistor DL drops sharply, the bias state of the low-side switching transistor DL switches from forward conduction to reverse cutoff, and the reverse recovery current flows from the cathode to the anode of the low-side switching transistor DL, causing the low-side detection voltage VD_L in Figure 2 to have a negative high voltage lower than GND at the moment when the -100V high voltage occurs, and the forward conduction current ID_L of the low-side switching transistor DL transitions at this time ②, that is, the forward conduction current ID_L of the low-side switching transistor DL cannot be cut off to 0 at the moment when the low-side switching transistor DL switches to reverse cutoff, but a reverse current appears, leading to a polarity transition of the low-side bus signal CANL in the CAN bus, and then leading to a corresponding transition of the differential signal VDIFF in the CAN bus ④, that is, an error occurs.

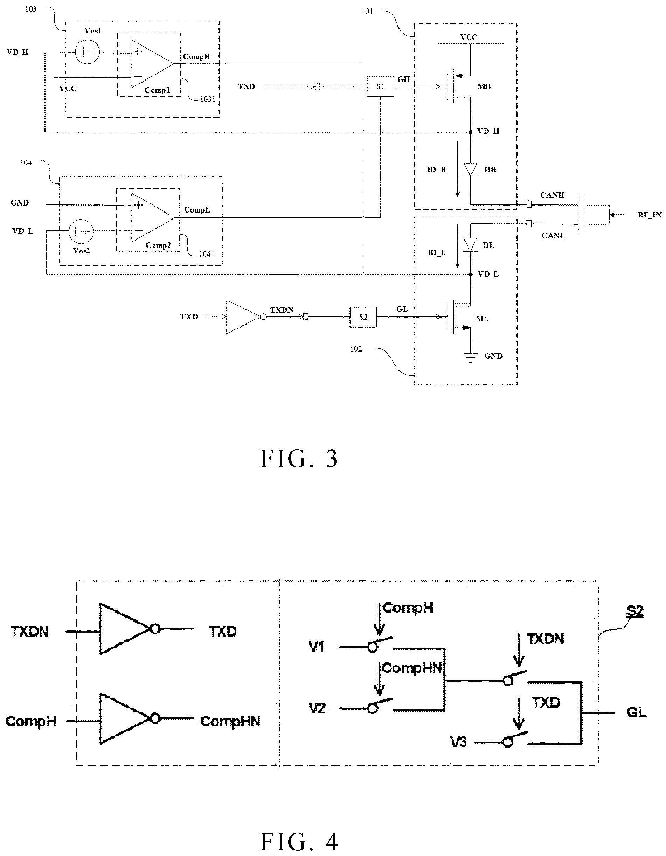

Figure 3 is a schematic diagram of a circuit structure of a CAN transceiver according to an embodiment of the present invention. As shown in Figure 3, the circuit structure of the CAN transceiver includes a data transmission port, a high-side bus port, a low-side bus port, a high-side transistor MH, a high-side switching transistor DH, a low-side transistor ML, a low-side switching transistor DL, a first regulation circuit 103, a second regulation circuit 104, and a logic circuit. The data transmission port receives a data transmission signal TXD, the high-side bus port outputs a high-side bus signal CANH, and the low-side bus port outputs a low-side bus signal CANL. The high-side transistor MH has a first terminal, a second terminal, and a third terminal, where the first terminal of the high-side transistor MH receives a supply voltage VCC, and the second terminal of the high-side transistor MH receives a high-side gate signal GH. The high-side switching transistor DH has a first terminal coupled to the third terminal of the high-side transistor MH, and a second terminal coupled to the high-side bus port, where the voltage at the first terminal of the high-side switching transistor DH is used as the high-side detection voltage VD_H in the present embodiment. The low-side transistor ML has a first terminal, a second terminal, and a third terminal, where the first terminal of the low-side transistor ML is coupled to a reference ground GND, and the second terminal of the low-side transistor ML receives a low-side gate signal GL. The low-side switching transistor DL has a first terminal coupled to the low-side bus port, and a second terminal coupled to the third terminal of the low-side transistor ML, where the voltage at the second terminal of the low-side switching transistor DL is used as the low-side detection voltage VD_L in the present embodiment. The first regulation circuit 103 has a first input terminal, a second input terminal, and an output terminal, where the first input terminal of the first regulation circuit 103 receives the supply voltage VCC, the second input terminal of the first regulation circuit 103 is coupled to the anode terminal of the high-side switching transistor DH to receive the high-side detection voltage VD_H, and the output terminal of the first regulation circuit 103 outputs a first regulation signal CompH according to the high-side detection voltage VD_H and the supply voltage VCC. The second regulation circuit 104 has a first input terminal, a second input terminal, and an output terminal, where the first input terminal of the second regulation circuit 104 is coupled to the reference ground GND, the second input terminal of the second regulation circuit 104 is coupled to the cathode terminal of the low-side switching transistor DL to receive the low-side detection voltage VD_L, and the output terminal of the second regulation circuit 104 outputs a second regulation signal CompL according to the low-side detection voltage VD_L and the reference ground GND.

Further, the first regulation circuit 103 includes a first regulation voltage source Vos1 and a first comparison circuit 1031. The first regulation voltage source Vos1 has a first terminal and a second terminal, where the first terminal of the first regulation voltage source Vos1 is coupled to the first terminal of the high-side switching transistor DH. The first comparison circuit 1031 has a first input terminal receiving the supply voltage VCC, a second input terminal coupled to the second terminal of the first regulation voltage source Vos1, and an output terminal coupled to the second terminal of the low-side transistor ML. The first regulation voltage source Vos1 provides a first threshold required for the first regulation circuit 103 to generate the first regulation signal CompH. The second regulation circuit 104 includes a second regulation voltage source Vos2 and a second comparison circuit 1041. The second regulation voltage source Vos2 has a first terminal and a second terminal, where the first terminal of the second regulation voltage source Vos2 is coupled to the second terminal of the low-side switching transistor DL. The second comparison circuit has a first input terminal coupled to the reference ground GND, a second input terminal coupled to the second terminal of the first regulation voltage source Vos1, and an output terminal coupled to the second terminal of the high-side transistor MH. The second regulation voltage source Vos2 provides a second threshold required for the second regulation circuit 104 to generate the second regulation signal CompL. In the present embodiment, the first comparison circuit 1031 includes a first comparator Comp1, where the first input terminal of the first comparison circuit 1031 is the inverting input terminal of the first comparator Comp1, the first regulation voltage source Vos1 is in a range from 0mV to 500mV, the first terminal of the first regulation voltage source Vos1 is the positive terminal of the power supply, and the second terminal of the first regulation voltage source Vos1 is the negative terminal of the power supply, so that the provided first threshold is from 0mV to 500mV. The second comparison circuit 1041 includes a second comparator Comp2, where the first input terminal of the second comparison circuit is the positive input terminal of the second comparator Comp2, the second regulation voltage source Vos2 is in a range from 0mV to 500mV, the first terminal of the second regulation voltage source Vos2 is the negative terminal of the power supply, and the second terminal of the second regulation voltage source Vos2 is the positive terminal of the power supply, so that the provided second threshold is from -500mV to 0mV.

In the above embodiment, when the voltage at the first terminal of the high-side switching transistor DH is greater than the sum of the supply voltage VCC and the voltage of the first regulation voltage source Vos1, that is, when the high-side detection voltage VD_H is greater than the sum of the supply voltage VCC and the first threshold, the first regulation circuit 103 increases the voltage at the second terminal of the low-side transistor ML by outputting the first regulation signal CompH, and increases the conduction current of the low-side transistor ML by increasing the bias voltage of the low-side transistor ML, that is, increases the forward conduction current ID_L of the low-side switching transistor DL. When the voltage at the second terminal of the low-side switching transistor DL is less than the negative value of the voltage of the second regulation voltage source, that is, when the low-side detection voltage VD_L is less than the second threshold, the second regulation circuit 104 outputs the second regulation signal CompL to reduce the voltage at the second terminal of the high-side transistor MH, and increases the conduction current of the high-side transistor MH by increasing the bias voltage of the high-side transistor MH, that is, increases the forward conduction current ID_H of the high-side switching transistor DH.

In the circuit structure of the CAN transceiver shown in Figure 3, the logic circuit includes a logic switch S1 (for example, a first logic switch) and a logic switch S2 (for example, a second logic switch), where an output terminal of the logic switch S1 is coupled to the second terminal of the high-side transistor MH, an output terminal of the logic switch S2 is coupled to the second terminal of the low-side transistor ML, the logic switch S2 generates the low-side gate signal GL according to the first regulation signal CompH and the data transmission inverted signal TXDN, and the logic switch S1 generates the high-side gate signal GH according to the second regulation signal CompL and the data transmission signal TXD; further, in order to unify the gate voltage selection logic of the high-side transistor MH and the low-side transistor ML and use the same logic switch structure, after the data transmission port receives the data transmission signal TXD, the data transmission signal TXD is input to the logic switch S1 through one path of the data transmission port and is input to the high-side output stage circuit 101 through the logic switch S1, and the data transmission signal TXD is inverted through another path of the data transmission port to generate the data transmission inverted signal TXDN, and the data transmission inverted signal TXDN then is input to the logic switch S2 and is input to the low-side output stage circuit 102 through the logic switch S2. Through the logic switch S1 and the logic switch S2, the data transmission signal line and the data transmission inverted signal line can be prevented from directly participating in the control logic of the high-side transistor MH and the low-side transistor ML, so as to prevent short circuits of root logic lines. In the present embodiment, the root logic lines correspond to the transmission lines for transmitting the data transmission signal TXD and the data transmission inverted signal TXDN.

In the embodiment shown in Figure 3, the high-side transistor MH is a P-channel field effect transistor, and the low-side transistor ML is an N-channel field effect transistor.

In the above embodiments, the high-side switching transistor DH and the low-side switching transistor DL in the high-side output stage circuit 101 and the low-side output stage circuit 102 can adopt field effect transistors or diodes.

Figure 4 is a schematic diagram of a logic switch S2 according to an embodiment of the present invention. The operation process of the logic switch S2 is described with reference to the CAN transceiver shown in Figure 3. As shown in Figure 4, the logic switch S2 outputs the low-side gate signal GL at an output terminal coupled to the gate of the low-side transistor ML according to the data transmission signal TXD, the data transmission inverted signal TXDN, the first regulation signal CompH of the first regulation circuit 103, and the first regulation inverted signal CompHN. Meanwhile, three selection voltages V1>V2>V3=0 are set, where the first regulation inverted signal CompHN is a complementary signal of the first regulation signal CompH, that is, when the first regulation signal CompH is at a logic high level, the first regulation inverted signal CompHN is at a logic low level, and when the first regulation signal CompH is at a logic low level, the first regulation inverted signal CompHN is at a logic high level. When the CAN transceiver operates in a recessive state, the data transmission signal TXD is at a logic high level, so that GL=V3, and the low-side transistor ML operates in a cut-off state. When the CAN transceiver operates in a dominant state, the data transmission inverted signal TXDN is at a logic high level, and the logic switch S2 selects the low-side gate signal GL as V1 or V2 according to the first regulation signal CompH and the first regulation inverted signal CompHN. When the first regulation signal CompH is at a logic high level, the low-side gate signal GL is V1; when the first regulation inverted signal CompHN is at a logic high level, the low-side gate signal GL is V2. Thus, when the voltage at the first terminal of the high-side switching transistor DH, i.e., the high-side detection voltage VD_H, is greater than the sum of the supply voltage VCC and the voltage of the first regulation voltage source Vos1, the first regulation circuit 103 controls the bias voltage of the low-side transistor ML, i.e., the low-side gate signal GL, to change from V2 to V1 by outputting the first regulation signal CompH, so as to increase the conduction current of the low-side transistor ML, i.e., increase the forward current ID_L of the low-side switching transistor DL. Similarly, the logic switch S1 in the embodiment shown in Figure 3 has a similar structure and the same principle as the logic switch S2 in the present embodiment. Correspondingly, the selection logic voltages V1, V2, and V3 are set as V1<V2<V3=VCC, and their specific structures and principles will not be described in detail here.

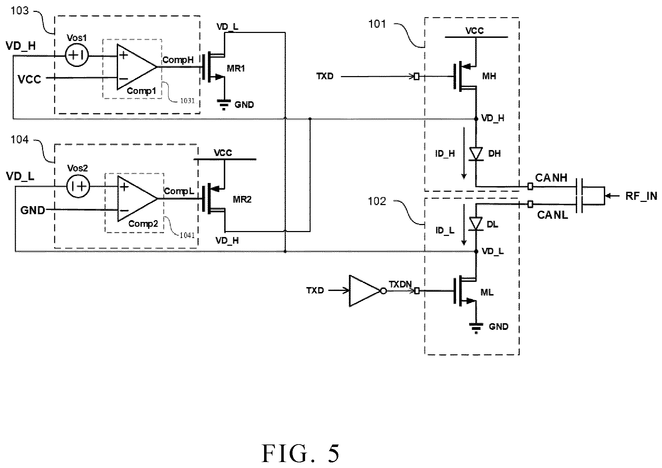

Figure 5 is a schematic diagram of a circuit structure of a CAN transceiver according to an embodiment of the present invention. As shown in Figure 5, the circuit structure of the CAN transceiver includes a data transmission port, a high-side bus port, a low-side bus port, a high-side transistor MH, a high-side switching transistor DH, a low-side transistor ML, a low-side switching transistor DL, a first regulation circuit 103, and a second regulation circuit 104. After the data transmission port receives the data transmission signal TXD, the high-side output stage circuit 101 receives the data transmission signal TXD, and the low-side output stage circuit 102 receives the data transmission inverted signal TXDN, where the data transmission inverted signal TXDN is a complementary signal of the data transmission signal TXD. The high-side bus port outputs a high-side bus signal CANH, and the low-side bus port outputs a low-side bus signal CANL. The high-side transistor MH has a first terminal, a second terminal, and a third terminal, where the first terminal of the high-side transistor MH receives a supply voltage VCC, and the second terminal of the high-side transistor MH receives the data transmission signal TXD. The high-side switching transistor DH has a first terminal coupled to the third terminal of the high-side transistor MH, and a second terminal coupled to the high-side bus port, where the voltage at the first terminal of the high-side switching transistor DH is used as the high-side detection voltage VD_H in the present embodiment. The low-side transistor ML has a first terminal, a second terminal, and a third terminal, where the first terminal of the low-side transistor ML is coupled to a reference ground GND, and the second terminal of the low-side transistor ML receives the data transmission inverted signal TXDN. The low-side switching transistor DL has a first terminal coupled to the low-side bus port, and a second terminal coupled to the third terminal of the low-side transistor ML, where the voltage at the second terminal of the low-side switching transistor DL is used as the low-side detection voltage VD_L in the present embodiment. The first regulation circuit 103 has a first input terminal, a second input terminal, and an output terminal, where the first input terminal of the first regulation circuit 103 receives the supply voltage VCC, the second input terminal of the first regulation circuit 103 is coupled to the first terminal of the high-side switching transistor DH to receive the high-side detection voltage VD_H, and the output terminal of the first regulation circuit 103 is coupled to the second terminal of the low-side switching transistor DL to output a first regulation signal CompH according to the high-side detection voltage VD_H and the supply voltage VCC. The second regulation circuit 104 has a first input terminal, a second input terminal, and an output terminal, where the first input terminal of the second regulation circuit 104 is coupled to the reference ground GND, the second input terminal of the second regulation circuit 104 is coupled to the second terminal of the low-side switching transistor DL to receive the low-side detection voltage VD_L, and the output terminal of the second regulation circuit 104 is coupled to the first terminal of the high-side switching transistor DH to output a second regulation signal CompL according to the low-side detection voltage VD_L and the reference ground GND.

The circuit structure of the CAN transceiver shown in Figure 5 further includes a first regulation transistor MR1 and a second regulation transistor MR2. The first regulation transistor MR1 has a first terminal, a second terminal, and a third terminal, where the first terminal of the first regulation transistor MR1 is coupled to the second terminal of the low-side switching transistor DL, the second terminal of the first regulation transistor MR1 is coupled to the reference ground GND, and the third terminal of the first regulation transistor MR1 receives the first regulation signal CompH; the second regulation transistor MR2 has a first terminal, a second terminal, and a third terminal, where the first terminal of the second regulation transistor MR2 is coupled to the supply voltage VCC, the second terminal of the second regulation transistor MR2 is coupled to the first terminal of the high-side switching transistor DH, and the third terminal of the second regulation transistor MR2 receives the second regulation signal CompL.

Further, the first regulation circuit 103 includes a first regulation voltage source Vos1 and a first comparison circuit 1031, where the first regulation voltage source Vos1 has a first terminal and a second terminal, where the first terminal of the first regulation voltage source Vos1 is coupled to the first terminal of the high-side switching transistor DH. The first comparison circuit 1031 has a first input terminal, a second input terminal, and an output terminal, where the first input terminal of the first comparison circuit 1031 receives the supply voltage VCC, the second input terminal of the first comparison circuit 1031 is coupled to the second terminal of the first regulation voltage source Vos1, and the output terminal of the first comparison circuit 1031 is coupled to the third terminal of the first regulation transistor MR1 to output the first regulation signal CompH. The first regulation voltage source Vos1 provides a first threshold required for the first regulation circuit 103 to generate the first regulation signal CompH. The second regulation circuit 104 includes a second regulation voltage source Vos2 and a second comparison circuit 1041, where the second regulation voltage source Vos2 has a first terminal and a second terminal, where the first terminal of the second regulation voltage source Vos2 is coupled to the second terminal of the low-side switching transistor DL, the second comparison circuit 1041 has a first input terminal, a second input terminal, and an output terminal, where the first input terminal of the second comparison circuit 1041 is coupled to the reference ground GND, the second input terminal of the second comparison circuit 1041 is coupled to the second terminal of the first regulation voltage source Vos1, and the output terminal of the second comparison circuit 1041 is coupled to the third terminal of the second regulation transistor MR2 to output the second regulation signal CompL. The second regulation voltage source Vos2 provides a second threshold required for the second regulation circuit 104 to generate the second regulation signal CompL. In the present embodiment, the first comparison circuit 1031 includes a first comparator Comp1, where the first input terminal of the first comparison circuit 1031 is the positive input terminal of the first comparator Comp1, the first regulation transistor MR1 is an N-channel field effect transistor, the first regulation voltage source Vos1 is in a range from 0mV to 500mV, the first terminal of the first regulation voltage source Vos1 is the positive terminal of the power supply, and the second terminal of the first regulation voltage source Vos1 is the negative terminal of the power supply, so that the provided first threshold is from 0mV to 500mV; the second comparison circuit 1041 includes a second comparator Comp2, where the first input terminal of the second comparison circuit 1041 is the positive input terminal of the second comparator Comp1, the second regulation transistor MR2 is a P-channel field effect transistor, the second regulation voltage source Vos2 is in a range from 0mV to 500mV, the first terminal of the second regulation voltage source Vos2 is the negative terminal of the power supply, and the second terminal of the second regulation voltage source Vos2 is the positive terminal of the power supply, so that the provided second threshold is from -500mV to 0mV. In the embodiment of the present application, normal fluctuations in the bus signal may cause the high-voltage detection signal VD_H to be close to the supply voltage VCC or slightly higher than the supply voltage VCC, and may also cause the low-voltage detection signal VD_L to be slightly lower than the reference voltage GND, leading to false triggering of the regulation mechanism of the circuit. The setting of the first threshold and the second threshold can prevent the regulation mechanism from being falsely triggered in the absence of abnormal high-voltage disturbances.

In the embodiment shown in Figure 5, when the voltage at the first terminal of the high-side switching transistor DH is greater than the sum of the supply voltage VCC and the voltage of the first regulation voltage source Vos1, the first comparison circuit 1031 in the first regulation circuit 103 outputs the first regulation signal CompH to the third terminal of the first regulation transistor MR1, to turn on the first regulation transistor MR1, thereby increasing the current flowing from the second terminal of the low-side switching transistor DL to the reference ground GND to supplement the current in the low-side bus of the CAN bus; when the voltage at the second terminal of the low-side switching transistor DL is less than the negative value of the voltage of the second regulation current source Vos2, the second comparison circuit 1041 in the second regulation circuit 104 outputs the second regulation signal CompL to the third terminal of the second regulation transistor MR2, to turn on the second regulation transistor MR2, thereby increasing the current flowing from the supply voltage VCC to the first terminal of the high-side switching transistor DH, i.e., the forward conduction current ID_H of the high-side switching transistor DH, to supplement the current in the high-side bus of the CAN bus.

In the embodiment shown in Figure 5, the high-side transistor MH is a P-channel field effect transistor, and the low-side transistor ML is an N-channel field effect transistor.

In another embodiment, the high-side switching transistor and the low-side switching transistor in the high-side output stage circuit 101 and the low-side output stage circuit 102 can adopt field effect transistors to replace the high-side switching transistor DH and the low-side switching transistor DL in the embodiment shown in Figure 5.

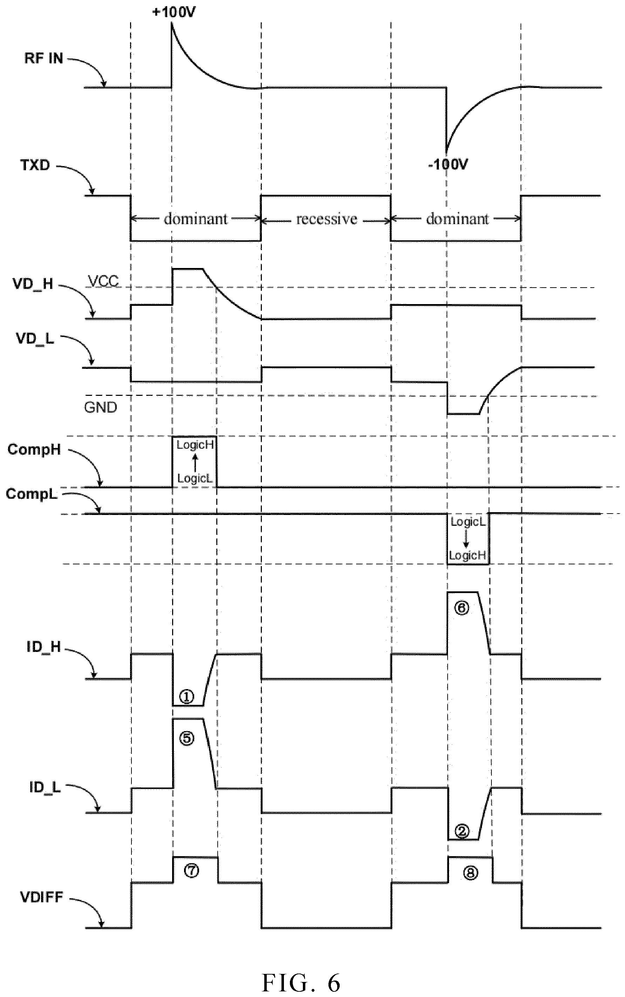

Figure 6 is an example diagram of signal timing of circuits of the CAN transceiver in various embodiments of the present invention, which is used to further illustrate the principle that the circuit structure of the CAN transceiver in the above embodiments improves EMC performance. Taking the example where a sudden IMP event or DPI event causes a +100V high-voltage interference in the CAN bus in the embodiment shown in Figure 3 or Figure 5, when a high-voltage interference signal RF_IN is coupled into the CAN bus through a capacitor, if the TXD signal is dominant at this time, at the moment when the IMP event or DPI event occurs, the voltage at the second terminal of the high-side switching transistor DH rises sharply, the bias state of the high-side switching transistor DH switches from forward conduction to reverse cutoff, and the reverse recovery current flows from the second terminal to the first terminal of the high-side switching transistor DH, causing the VD_H signal in Figure 2 to have a high voltage exceeding the supply voltage VCC at the moment when the +100V high voltage occurs, and the forward conduction current ID_H of the high-side switching transistor DH transitions at this time ①, that is, the forward conduction current ID_H of the high-side switching transistor DH cannot be cut off to 0 at the moment when the high-side switching transistor DH switches to reverse cutoff, but a reverse current appears, leading to a level transition or even a polarity transition in the high-side bus signal CANH in the CAN bus. However, according to the circuit structure of the first regulation circuit 103 in the above embodiments, it can be seen that the high-side detection voltage VD_H is collected to the second input terminal of the first regulation circuit 103 at this time, and after being compared with the supply voltage VCC, the first regulation circuit 103 generates the first regulation signal CompH. In the embodiment where the first comparison circuit 1031 adopts the first comparator Comp1, the voltage at the output terminal of Comp1 is the first regulation signal CompH, when the +100V high voltage occurs, the high-side detection voltage VD_H generates a corresponding transition voltage, causing the first regulation signal CompH to change from a logic low level LogicL to a logic high level LogicH, thereby increasing the bias voltage of the low-side transistor ML or turning on the first regulation transistor MR1, so that the forward conduction current ID_L of the low-side switching transistor DL transitions at this time ⑤, i.e., compensating the current in the low-side bus, so that the absolute value of the actual level in the low-side bus signal CANL increases accordingly, so that the polarity of the differential signal VDIFF does not transition to a state of logic low level or invert, but transitions as shown in Figure 6 ⑦. At this time, the differential signal VDIFF still represents dominance, i.e., preventing the generation of errors. The differential signal VDIFF is the difference signal between the high-side bus signal CANH and the low-side bus signal CANL in the CAN bus.

Similarly, when a sudden IMP event or DPI event causes a -100V high-voltage interference in the CAN bus, and the TXD signal is dominant at this time, at the moment when the IMP event or DPI event occurs, the voltage at the second terminal of the low-side switching transistor DL drops sharply, the bias state of the low-side switching transistor DL switches from forward conduction to reverse cutoff, and the reverse recovery current flows from the second terminal to the first terminal of the low-side switching transistor DL, causing the low-side detection voltage VD_L in Figure 2 to have a negative high voltage lower than the reference ground voltage GND at the moment when the -100V high voltage occurs, and ID_L transitions at this time ②, that is, the forward conduction current ID_L of the low-side switching transistor DL cannot be cut off to 0 at the moment when the low-side switching transistor DL switches to reverse cutoff, but a reverse current appears, leading to a level transition or even a polarity transition in the low-side bus signal CANL in the CAN bus. However, according to the circuit structure of the second regulation circuit 104 in the above embodiments, it can be seen that the low-side detection voltage VD_L is collected to the second input terminal of the second regulation circuit 104 at this time, and after being compared with the reference ground voltage GND, the second regulation circuit 104 generates the second regulation signal CompL. In the embodiment where the second comparison circuit 1041 adopts the second comparator Comp2, the voltage at the output terminal of Comp2 is the second regulation signal CompL, when the -100V high voltage occurs, the low-side detection voltage VD_L generates a corresponding transition voltage, causing the second regulation signal CompL to change from the logic low level LogicL to the logic high level LogicH, thereby increasing the bias of the high-side transistor MH or turning on the second regulation transistor MR2, so that the forward conduction current ID_H of the high-side diode DH transitions at this time ⑥, i.e., compensating the current in the high-side bus, so that the actual level in the high-side bus signal CANH increases accordingly, thereby compensating the actual level difference between the high-side bus signal CANH and the low-side bus signal CANL, that is, the polarity of the differential signal VDIFF does not transition to a state of logic low level or invert, but transitions as shown in Figure 5 ⑧. At this time, the differential signal VDIFF still represents dominance, i.e., preventing the generation of errors. The differential signal VDIFF is the difference signal between the high-side bus signal CANH and the low-side bus signal CANL in the CAN bus.

The circuit structures of the CAN transceivers provided by the embodiments of the present application utilize two regulation circuits to sample abnormal pulse voltages for the high-side output stage circuit 101 and the low-side output stage circuit 103 respectively, and by increasing pull-up and pull-down currents, prevent the dominant differential voltage from being too low due to the reverse recovery current of the switching transistor, and keep the differential voltage output by the bus stable, thereby improving the overall anti-interference capability of the circuit and enhancing the reliability and stability of communication.

Although the present invention has been described with reference to illustrative embodiments, the present specification is not intended to be interpreted in a restrictive sense. Various modifications and combinations of the illustrative embodiments, as well as other embodiments of the present invention, will be apparent to those skilled in the art upon reference to the specification. Therefore, it is intended that the appended claims cover all such modifications or embodiments.

## Claims

1. A CAN transceiver, **characterized in that** the CAN transceiver comprises:
a data transmission port, configured to receive a data transmission signal;
a high-side bus port (CANH), configured to output a high-side bus signal;
a low-side bus port (CANL), configured to output a low-side bus signal;
a high-side transistor (MH), having a first terminal, a second terminal, and a third terminal, wherein the first terminal of the high-side transistor (MH) is configured to receive a supply voltage, and the second terminal of the high-side transistor (MH) is configured to receive a high-side gate signal;
a high-side switching transistor (DH), having a first terminal coupled to the third terminal of the high-side transistor (MH), and a second terminal coupled to the high-side bus port (CANH), wherein a voltage at the first terminal of the high-side switching transistor (DH) is a high-side detection voltage;
a low-side transistor (ML), having a first terminal, a second terminal, and a third terminal, wherein the first terminal is coupled to a reference ground (GND), and the second terminal is configured to receive a low-side gate signal;
a low-side switching transistor (DL), having a first terminal coupled to the low-side bus port (CANL), and a second terminal coupled to the third terminal of the low-side transistor (ML), wherein a voltage at the second terminal of the low-side switching transistor (DL) is a low-side detection voltage;
a first regulation circuit (103), having a first input terminal and a second input terminal, wherein the first input terminal of the first regulation circuit (103) is configured to receive the supply voltage, and the second input terminal of the first regulation circuit (103) is configured to receive the high-side detection voltage, wherein the first regulation circuit (103) is configured to generate a first regulation signal according to the supply voltage and the high-side detection voltage;
a second regulation circuit (104), having a first input terminal and a second input terminal, wherein the first input terminal of the second regulation circuit (104) is coupled to the reference ground (GND), and the second input terminal of the second regulation circuit (104) is configured to receive the low-side detection voltage, wherein the second regulation circuit (104) is configured to generate a second regulation signal according to the reference ground (GND) and the low-side detection voltage; and
a logic circuit, configured to generate the high-side gate signal and the low-side gate signal according to the data transmission signal, the first regulation signal, and the second regulation signal;
wherein when the high-side detection voltage is greater than a sum of the supply voltage and a first threshold, a forward current flowing through the low-side switching transistor (DL) increases; and when the low-side detection voltage is less than a second threshold, a forward current flowing through the high-side switching transistor (DH) increases.

2. The CAN transceiver according to claim 1, wherein
the first regulation circuit (103) comprises a first regulation voltage source (Vos1) and a first comparison circuit (1031); wherein the first regulation voltage source (Vos1) comprises a first terminal and a second terminal, wherein the first terminal of the first regulation voltage source (Vos1) is coupled to the first terminal of the high-side switching transistor (DH); and the first comparison circuit (1031) comprises a first input terminal receiving the supply voltage, a second input terminal coupled to the second terminal of the first regulation voltage source (Vos1), and an output terminal coupled to the second terminal of the low-side transistor (ML); and
the second regulation circuit (104) comprises a second regulation voltage source (Vos2) and a second comparison circuit (1041); wherein the second regulation voltage source (Vos2) comprises a first terminal and a second terminal, wherein the first terminal of the second regulation voltage source (Vos2) is coupled to the second terminal of the low-side switching transistor (DL); and the second comparison circuit (1041) comprises a first input terminal coupled to the reference ground (GND), a second input terminal coupled to the second terminal of the first regulation voltage source (Vos1), and an output terminal coupled to the second terminal of the high-side transistor (MH).

3. The CAN transceiver according to claim 1, wherein the logic circuit comprises a first logic switch (S1) and a second logic switch (S2), wherein an output terminal of the first logic switch (S1) is coupled to the second terminal of the high-side transistor (MH), and an output terminal of the second logic switch (S2) is coupled to the second terminal of the low-side transistor (ML).

4. The CAN transceiver according to claim 1, wherein when the high-side detection voltage is greater than the sum of the supply voltage and the first threshold, a current flowing through the low-side transistor (ML) is controlled to increase by the low-side gate signal; and when the low-side detection voltage is less than the second threshold, a current flowing through the high-side transistor (MH) is controlled to increase by the high-side gate signal.

5. The CAN transceiver according to claim 1, wherein the first threshold is in a range from 0mV to 500mV.

6. The CAN transceiver according to claim 1, wherein the second threshold is in a range from -500mV to 0mV.

7. The CAN transceiver according to claim 1, wherein the high-side transistor (MH) is a P-type field effect transistor, and the low-side transistor (ML) is an N-type field effect transistor.

8. The CAN transceiver according to claim 1, wherein the high-side switching transistor (DH) and the low-side switching transistor (DL) comprise field effect transistors or diodes.

9. A CAN transceiver, **characterized in that** the CAN transceiver comprises:
a data transmission port, configured to receive a data transmission signal;
a high-side bus port (CANH), configured to output a high-side bus signal;
a low-side bus port (CANL), configured to output a low-side bus signal;
a high-side transistor (MH), having a first terminal, a second terminal, and a third terminal, wherein the first terminal of the high-side transistor (MH) is configured to receive a supply voltage, and the second terminal of the high-side transistor (MH) is configured to receive the data transmission signal;
a high-side switching transistor (DH), having a first terminal coupled to the third terminal of the high-side transistor (MH), and a second terminal coupled to the high-side bus port (CANH), wherein a voltage at the first terminal of the high-side switching transistor (DH) is a high-side detection voltage;
a low-side transistor (ML), having a first terminal, a second terminal, and a third terminal, wherein the first terminal of the low-side transistor (ML) is coupled to a reference ground (GND), and the second terminal of the low-side transistor (ML) is configured to receive a data transmission inverted signal;
a low-side switching transistor (DL), having a first terminal coupled to the low-side bus port (CANL), and a second terminal coupled to the third terminal of the low-side transistor (ML), wherein a voltage at the second terminal of the low-side switching transistor (DL) is a low-side detection voltage;
a first regulation circuit (103), having a first input terminal and a second input terminal, wherein the first input terminal of the first regulation circuit (103) is configured to receive the supply voltage, and the second input terminal of the first regulation circuit (103) is configured to receive the high-side detection voltage, wherein the first regulation circuit (103) generates a first regulation signal according to the supply voltage and the high-side detection voltage;
a second regulation circuit (104), having a first input terminal and a second input terminal, wherein the first input terminal of the second regulation circuit (104) is coupled to the reference ground (GND), and the second input terminal of the second regulation circuit (104) is configured to receive the low-side detection voltage, wherein the second regulation circuit (104) generates a second regulation signal according to the reference ground (GND) and the low-side detection voltage;
a first regulation transistor (MR1), having a first terminal, a second terminal, and a third terminal, wherein the first terminal of the first regulation transistor (MR1) is coupled to the second terminal of the low-side switching transistor (DL), the second terminal of the first regulation transistor (MR1) is coupled to the reference ground (GND), and the third terminal of the first regulation transistor (MR1) is configured to receive the first regulation signal; and
a second regulation transistor (MR2), having a first terminal, a second terminal, and a third terminal, wherein the first terminal of the second regulation transistor (MR2) is coupled to the supply voltage, the second terminal of the second regulation transistor (MR2) is coupled to the first terminal of the high-side switching transistor (DH), and the third terminal of the second regulation transistor (MR2) is configured to receive the second regulation signal;
wherein when the high-side detection voltage is greater than a sum of the supply voltage and a first threshold, a forward current flowing through the low-side switching transistor (DL) increases; and when the low-side detection voltage is less than a second threshold, a forward current flowing through the high-side switching transistor (DH) increases.

10. The CAN transceiver according to claim 9, wherein
the first regulation circuit (103) comprises a first regulation voltage source (Vos1) and a first comparison circuit (1031), wherein the first regulation voltage source (Vos1) comprises a first terminal and a second terminal, wherein the first terminal of the first regulation voltage source (Vos1) is coupled to the first terminal of the high-side switching transistor (DH); and the first comparison circuit (1031) comprises a first input terminal, a second input terminal, and an output terminal, wherein the first input terminal of the first comparison circuit (1031) is configured to receive the supply voltage, the second input terminal of the first comparison circuit (1031) is coupled to the second terminal of the first regulation voltage source (Vos1), and the output terminal of the first comparison circuit (1031) is coupled to the third terminal of the first regulation transistor (MR1) to output the first regulation signal; and
the second regulation circuit (104) comprises a second regulation voltage source (Vos2) and a second comparison circuit (1041), wherein the second regulation voltage source (Vos2) comprises a first terminal and a second terminal, wherein the first terminal of the second regulation voltage source (Vos2) is coupled to the second terminal of the low-side switching transistor (DL); and the second comparison circuit (1041) comprises a first input terminal, a second input terminal, and an output terminal, wherein the first input terminal of the second comparison circuit (1041) is coupled to the reference ground (GND), the second input terminal of the second comparison circuit (1041) is coupled to the second terminal of the first regulation voltage source (Vos1), and the output terminal of the second comparison circuit (1041) is coupled to the third terminal of the second regulation transistor (MR2) to output the second regulation signal.

11. The CAN transceiver according to claim 9, wherein when the high-side detection voltage is greater than the sum of the supply voltage and the first threshold, the first regulation transistor (MR1) is controlled to be conducting by the first regulation signal; and when the low-side detection voltage is less than the second threshold, the second regulation transistor (MR2) is controlled to be conducting by the second regulation signal.

12. The CAN transceiver according to claim 9, wherein the first threshold is in a range from 0mV to 500mV.

13. The CAN transceiver according to claim 9, wherein the second threshold is in a range from -500mV to 0mV.

14. The CAN transceiver according to claim 9, wherein the high-side transistor (MH) is a P-channel field effect transistor, and the low-side transistor (ML) is an N-channel field effect transistor.

15. The CAN transceiver according to claim 9, wherein the first regulation transistor (MR1) is an N-channel field effect transistor, and the second regulation transistor (MR2) is a P-channel field effect transistor.
